Europäisches Patentamt

European Patent Office

Office européen des brevets

(11) Veröffentlichungsnummer: **0 059 774**
**B1**

(12) **EUROPÄISCHE PATENTSCHRIFT**

(45) Veröffentlichungstag der Patentschrift:
**25.06.86**

(21) Anmeldenummer: **81101734.2**

(22) Anmeldetag: **10.03.81**

(51) Int. Cl.⁴: **G 05 B 23/02,** G 07 C 3/00

(54) **Verfahren zum Prüfen und Überwachen von induktiven Gleichspannungsverbrauchern in elektrischen Haushaltgeräten.**

(43) Veröffentlichungstag der Anmeldung:
**15.09.82 Patentblatt 82/37**

(45) Bekanntmachung des Hinweises auf die Patenterteilung:
**25.06.86 Patentblatt 86/26**

(84) Benannte Vertragsstaaten:
**DE FR GB IT SE**

(56) Entgegenhaltungen:
**DD - A - 141 213**
**DE - A - 2 251 472**
**DE - A - 2 805 876**
**DE - B - 2 353 660**

(73) Patentinhaber: **Bauknecht Hausgeräte GmbH, Am Wallgraben 99, D-7000 Stuttgart 80 (DE)**

(72) Erfinder: **Siffrin, Eugen, Flözstrasse 5, D-6652 Bexbach (DE)**

(74) Vertreter: **Meier, Friedrich, Dipl.-Ing. et al, c/o PHILIPS PATENTVERWALTUNG GMBH Billstrasse 80 Postfach 10 51 49, D-2000 Hamburg 28 (DE)**

## Beschreibung

Die Erfindung bezieht sich auf ein Verfahren zum Prüfen und Überwachen von induktiven Gleichspannungsverbrauchern auf Funktion und gegebenenfalls auch Betriebszustand in elektrischen Haushaltgeräten, die durch Programmsteuereinrichtungen über vorgeschaltete Verstärker, vorzugsweise Inverter, einschaltbar sind.

Bei elektrischen Geräten, die mit Programmsteuereinrichtungen arbeiten, werden in zunehmendem Masse als Steuereinrichtungen elektronische Steuereinheiten, z.B. Mikrocomputer, eingesetzt, die sehr umfangreiche Steuerprogramme zulassen und darüber hinaus ermögliche, Sonderfunktionen zu erfüllen, wie z.B. eine Eigenüberwachung der Betriebseinrichtungen, sowie eine Fehlerermittlung, die dem Service u.a. nicht nur Betriebsstörungen, sondern auch Betriebsausfälle und die Art der Störung angeben können.

Bei elektrischen Haushaltgeräten sind ein grosser Teil der Betriebseinrichtungen induktive Gleichspannungsverbraucher, wie magnetische Antriebe für Wasserventile, Relais für Leistungsverbraucher, Klarspülmittelgeber, Reinigungsmittelgeber usw. oder auch Motoren. Der Erfindung liegt die Aufgabe zugrunde, derartige Betriebseinrichtungen, ihr zugehörigen Schalt- und Steuerelemente sowie die Leitungsführungen zu prüfen, zu überwachen und gegebenenfalls auch ihren Betriebszustand zu ermitteln.

Aus der DE-A-2 251 472 ist eine Schaltungsanordnung zum Kontrollieren der mechanischen Bewegung eines Magnetventilankers bekannt. Bei dieser Anordnung ist ein Schwellwertschalter vorgesehen, der über eine Differenzierschaltung an eine Einrichtung zum Messen des durch die Magnetwicklung fliessenden Stromes angeschlossen ist. Die Differenzierschaltung spricht an auf die kurzzeitige Änderung des Stromanstieges bei Bewegung des Magnetankers. Bei dieser Anordnung ist also eine Bewegung des Magnetankers und deshalb eine Betriebszustandsänderung erforderlich. Dies ist jedoch bei Betrieb eines Gerätes nicht immer zulässig.

Gemäss der Erfindung wird die Aufgabe bei einem Verfahren der beschriebenen Art dadurch gelöst, dass die den Betriebszustand bestimmende, an den Verbraucher angelegte Steuerspannung kurzzeitig über den vorgeschalteten Verstärker angelegt oder abgeschaltet wird und die sich aus der Energieänderung des Verbrauchers beim Abschaltvorgang ergebende impulsförmige Spannungsänderung am Verbraucher erfasst und nach Höhe und gegebenenfalls auch Impulslänge (Zeit) ausgewertet wird.

Bei der Ansteuerung der Verbraucher, insbesondere während des Betriebes, zum Zwecke des Prüfens und Überwachens ist es notwendig, die Steuerspannungsänderung derart kurzzeitig auszuführen, dass keine Änderung des Betriebszustandes des Verbrauchers erfolgt. Bei einem eingeschalteten Magnetventil erfolgt z.B. die Steuerspannungsunterbrechung so kurzzeitig, dass das Ventil während des Prüfvorganges nicht betätigt wird.

Vorteilhaft ist es, bei einem Verfahren nach der Erfindung einen auch für die Steuerprogramme vorgesehenen Mikrocomputer einzusetzen und diesem einerseits die Funktion zuzuordnen, die verschiedenen Betriebseinrichtungen, soweit sie mit induktiven Gleichspannungsverbrauchern beschaltet sind, nacheinander anzusteuern und andererseits die sich ergebende Spannungsänderung als Signalspannung auch auszuwerten. Die Auswertung kann dabei sowohl nach Spannungsimpulsgrösse als auch nach der Länge des erfassten Spannungsimpulses ausgewertet werden. Insbesondere bei der vergleichenden Auswertung der Impulslänge lässt sich auch eine Aussage darüber machen, in welchem Betriebszustand, z.B. während eines normalen Programmablaufes, sich die einzelnen Gleichspannungsverbraucher befinden.

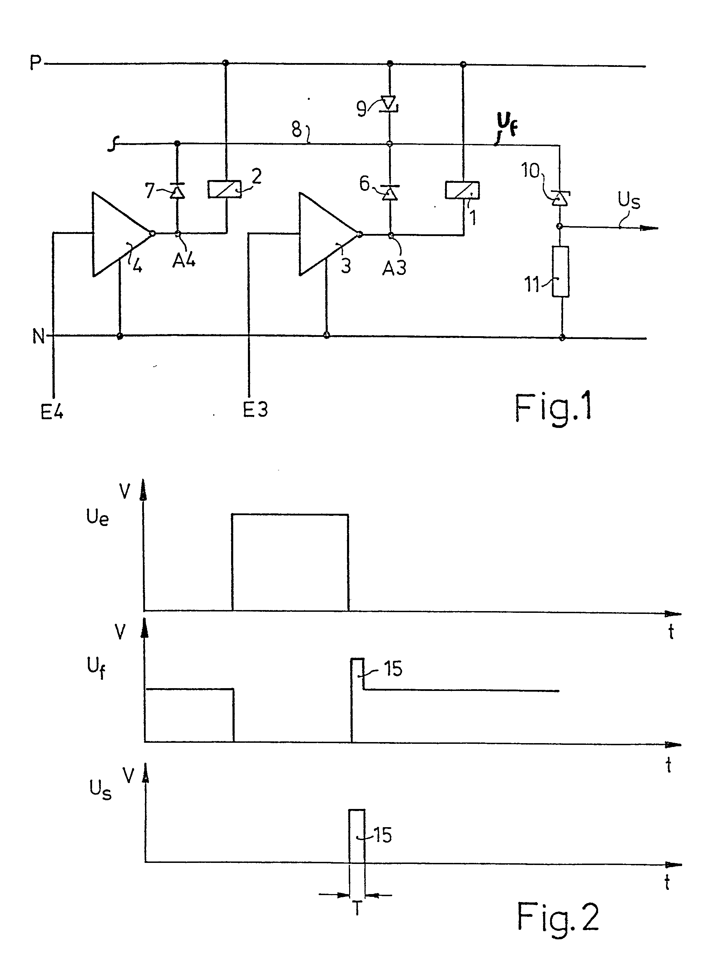

Ein Verfahren der beschriebenen Art wird an Hand der Schaltung nach Figur 1 beschrieben und die Wirkungsweise an Hand der Darstellung nach Figur 2 erläutert.

Die Figur 1 zeigt eine Schaltungsanordnung zur Durchführung des Verfahrens nach der Erfindung.

Die Figur 2 zeigt in einem dreiteiligen Diagramm die Wirkungsweise einer Schaltungsanordnung nach Fig. 1.

Aus dem Netz P, N werden induktive Gleichspannungsverbraucher, wie ein Relais 1 z.B. zum Zuschalten der Heizung, sowie ein Magnetventil 2 beispielhaft für eine Vielzahl solcher Betriebseinrichtungen eingespeist. Die Verbraucher 1 und 2 werden jeweils über die Verstärker 3 und 4 angesteuert, deren Eingänge mit E3 und E4 bezeichnet sind. Die Verstärker 3 und 4 sind als Inverter so ausgebildet, dass beim Anliegen einer Steuerspannung an den Eingängen E3, E4 die Verbraucher 1, 2 an Spannung liegen. Parallel zu den Verbrauchern 1 und 2 liegen jeweils Dioden 6 bzw. 7, die über eine gemeinsame Sammelleitung 8 auf eine Zenerdiode 9 geschaltet sind. Die Sammelleitung 8 ist mit einem Spannungsteiler verbunden, der aus der Zenerdiode 10 und dem Widerstand 11 besteht. Am Spannungsteiler 10, 11 wird die Signalspannung Us abgegriffen.

Die Wirkungsweise der aus Fig. 1 ersichtlichen Schaltungsanordnung sei an Hand der Figur 2 erläutert. Liegt an E3 eine Steuerspannung an, so liegt am Ausgang A3 des Inverters 3 das negative Potential des Netzes P, N an und das Relais 1 ist eingeschaltet. Entsprechendes gilt auch für die Steuerspannung an E4 und dem zugehörigen Ausgang A4 für den Verbraucher 2.

Wird an E3 kurzzeitig Spannung Ue angelegt, so wird Uf zu Null und damit der Verbraucher 1 an die Netzspannung gelegt. Beim Wegnehmen der Spannung Ue wird der Verbraucher wieder entregt, so dass sich der Verbraucher 1 über die Diode 6 und die Zenerdiode 9 sowie den ohmschen Spulenwiderstand des Verbrauchers 1 entlädt. Die dabei auftretende, aus Fig. 2 ersichtliche Spannungsspitze 15 von Uf wird als Signalspannung Us zwischen der Zenerdiode 10 und dem

Widerstand 11 entsprechend Fig. 2 abgegriffen.

Die Zenerdiode 10 ist dabei so bemessen, dass die an ihr abfallende Spannung kleiner ist als die sich aus der Entregung des Verbrauchers 1 an der Leitung 8 ergebende Spannung. Als Beispiele seien angegeben die Zenerspannung an der Diode 9 mit 12 V bei einer Netzspannung von 24 V, die Zenerspannung an der Diode 10 = 30 V. Damit würde sich eine Entregungsspannungsspitze des Verbrauchers 1 von 36 V und eine Signalspannung Us = 6 V ergeben.

Die Signalspannungsspitze sagt aus, dass eine Induktivität angeschlossen ist. Die Impulslänge dieser Signalspannung Us, in Fig. 2 mit T bezeichnet, sagt etwas über den Betriebszustand des Verbrauchers oder die Grösse der Induktivität aus. Ist bei einem Relais der Anker angezogen, so ergibt sich eine längere Impulsdauer als bei abgefallenem Anker.

Die Auswertung im Mikrocomputer erfolgt unter Berücksichtigung vorgegebener Vergleichswerte sowohl hinsichtlich der Spannungsspitze als auch hinsichtlich der Länge des Spannungsimpulses Us.

## Patentansprüche

1. Verfahren zum Prüfen und Überwachen von induktiven Gleichspannungsverbrauchern auf Funktion und gegebenenfalls auch auf Betriebszustand in elektrischen Haushaltgeräten, die durch Programmsteuereinrichtungen über vorgeschaltete, als elektronisch gesteuerte Schalter wirkende Verstärker, vorzugsweise Inverter, einschaltbar sind, dadurch gekennzeichnet, dass über den vorgeschalteten Verstärker an den Verbraucher eine den Betriebszustand bestimmende Steuerspannung ($U_e$) so kurzzeitig angelegt oder abgeschaltet wird, dass keine Änderung des Betriebszustandes des Verbrauchers erfolgt und dass die sich aus der Energieänderung des Verbrauchers (1, 2) beim Abschaltvorgang ergebende impulsförmige Spannungsänderung (15) am Verbraucher erfasst und nach Höhe und gegebenenfalls auch Impulslänge (T) ausgewertet wird.

2. Verfahren nach Anspruch 1, dadurch gekennzeichnet, dass die kurzzeitige Änderung der Steuerspannung über eine elektronische Steuereinheit, z. B. einen Mikrocomputer, erfolgt und die Signalspannungsänderung in der gleichen Steuereinheit ausgewertet wird.

3. Verfahren nach Anspruch 2, dadurch gekennzeichnet, dass die elektronische Steuereinheit eine Mehrzahl induktiver Verbraucher zeitlich versetzt ansteuert.

4. Schaltungsanordnung zur Durchführung des Verfahrens nach einem der Ansprüche 1 bis 3, dadurch gekennzeichnet, dass jedem Verbraucher (1, 2) gegen die Betriebsspannung eine Serienschaltung aus einer Freilaufdiode (6) und einer Zenerdiode (9) parallel geschaltet ist, und dass die zwischen den Dioden abgreifbare Spannung als Signalspannung ($U_f$) abgenommen wird.

5. Schaltungsanordnung nach Anspruch 4, dadurch gekennzeichnet, dass alle den Verbrauchern (1, 2) parallel geschalteten Freilaufdioden (6, 7) mit einer einzigen, an der Betriebsspannung liegenden Zenerdiode (9) beschaltet sind.

6. Schaltungsanordnung nach Anspruch 4 oder 5, dadurch gekennzeichnet, dass die Signalspannung ($U_f$) einem Spannungsteiler, bestehend aus einer zumindest die Betriebsspannung eliminierenden Zenerdiode (10) und einem Ableitwiderstand (11), zugeleitet und von diesem die für die Auswertung wesentliche impulsförmige Spannung (Us) abgenommen wird.

## Claims

1. A method of testing and monitoring inductive direct voltage loads with respect to function and, as the case may be, also with respect to operating condition in electrical domestic apparatus, which can be switched on by means of program control devices through preceding amplifiers acting as electronically controlled switches, preferably inverters, characterized in that a control voltage ($U_e$) determining the operating condition is applied through the preceding amplifier to the load or is switched off for such a short time that no variation of the operation condition of the load occurs, and in that the pulsatory voltage variation (15) resulting from the energy variation of the load (1, 2) during the switching-off process is measured at the load and is evaluated with respect to height and, as the case may be, also with respect to pulse length (T).

2. A method as claimed in Claim 1, characterized in that the trasient variation of the control voltage occurs via an electronic control unit, for example a microcomputer, and the signal voltage variation is evaluated in the same control unit.

3. A method as claimed in Claim 2, characterized in that the electronic control unit drives a plurality of inductive loads in a relationship offset in time.

4. A circuit arrangement for carrying out the method claimed in any one of the Claims 1 to 3, characterized in that a series-combination comprising a fly-wheel diode (6) and a Zener diode (9) is connected in parallel with each load with respect to the operating voltage and in that the voltage that can be taken off between the diodes is derived as signal voltage (Uf).

5. A circuit arrangement as claimed in Claim 4, characterized in that all the fly-wheel diodes (6, 7) connected in parallel with the loads (1, 2) are provided with a single Zener diode (9) applied to the operating voltage.

6. A circuit arrangement as claimed in Claim 4 or 5, characterized in that the signal voltage (Uf) is supplied to a voltage divider comprising a Zener diode (10) at least eliminating the operating voltage and a leakage resisitor (11) and in that the pulsatory voltage (Us) essential to the evaluation is derived therefrom.

**Revendications**

1. Procédé pour vérifier et surveiller le fonctionnement et, le cas échéant, l'état de marche de charges à tension continue dans des appareils électrodomestiques qui peuvent être mis en circuit par des dispositifs de commande à programme par l'intermédiaire d'amplificateurs fonctionnant comme des commutateurs électroniques, de préférence des inverseurs, caractérisé en ce que la tension de commande ($U_e$), qui détermine l'état de marche et qui est appliquée ou coupée par l'intermédiaire de l'amplificateur en série pendant un laps de temps si court qu'aucune modification de l'état de marche de la charge n'en résulte et que la variation de tension par impulsion (15) résultant de la variation d'énergie de la charge (1, 2) lors de l'opération de coupure, est détectée au niveau de la charge et est évaluée d'après sa hauteur et, le cas échéant, d'après sa durée d'impulsion (T).

2. Procédé suivant la revendication 1, caractérisé en ce que la variation de courte durée de la tension de commande s'effectue par l'intermédiaire d'une unité de commande électronique, par exemple d'un micro-ordinateur, et la variation de la tension de signal est évaluée dans la même unité de commande.

3. Procédé suivant la revendication 2, caractérisé en ce que l'unité de commande électronique excite avec un certain décalage dans le temps plusieurs charges inductives.

4. Montage de circuit pour l'exécution du procédé suivant l'une quelconque des revendications 1 à 3, caractérisé en ce qu'à chaque charge (1, 2) par rapport à la tension de fonctionnement est connecté en parallèle un montage en série d'une diode de roue libre (6) et d'une diode Zener (9) et la tension pouvant être prélevée entre les diodes est obtenue en tant que tension de signal (Uf).

5. Montage de circuit suivant la revendication 4, caractérisé en ce que toutes les diodes de roue libre (6, 7) connectées en parallèle aux charges (1, 2) sont reliées à une diode de Zener (9) unique branchée sur la tension de fonctionnement.

6. Montage de circuit suivant la revendication 4 ou 5, caractérisé en ce que la tension de signal (Uf) est fournie à un diviseur de tension formé d'une diode Zener (10) éliminant au moins la tension de fonctionnement et d'une résistance de dérivation (11) et la tension par impulsions (Us) essentielle pour l'évaluation est prélevée sur cette résistance.

Fig.1

Fig.2